(19) Europäisches Patentamt / European Patent Office / Office européen des brevets

(11) **EP 3 098 924 B1**

(12) **EUROPEAN PATENT SPECIFICATION**

(45) Date of publication and mention of the grant of the patent:
**28.10.2020 Bulletin 2020/44**

(51) Int Cl.:
**H02J 3/00** *(2006.01)* **G01R 19/25** *(2006.01)*

(21) Application number: **15305837.5**

(22) Date of filing: **29.05.2015**

(54) **A METHOD AND DEVICE FOR CALCULATION OF POWER FLOW IN THE DISTRIBUTION GRID**

VERFAHREN UND VORRICHTUNG ZUR BERECHNUNG DES ENERGIEFLUSSES IN DEM VERTEILERNETZ

PROCÉDÉ ET DISPOSITIF DE CALCUL D'UN FLUX D'ÉNERGIE DANS LE RÉSEAU DE DISTRIBUTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**30.11.2016 Bulletin 2016/48**

(73) Proprietor: **Electricité de France**
**75008 Paris (FR)**

(72) Inventors:
• **NIU, Xingyan U**
**310-1-301 Chaoyan (CN)**
• **YANG, Xavier**
**92160 ANTONY (FR)**

(74) Representative: **Plasseraud IP**
**66, rue de la Chaussée d'Antin**
**75440 Paris Cedex 09 (FR)**

(56) References cited:
**US-A1- 2013 204 556**

• **MEIJUN LIN ET AL: "Power Prediction Model of Grid-Connected Photovoltaic and Power Flow Analysis", POWER AND ENERGY ENGINEERING CONFERENCE (APPEEC), 2012 ASIA-PACIFIC, IEEE, 27 March 2012 (2012-03-27), pages 1-4, XP032239708, DOI: 10.1109/APPEEC.2012.6307195 ISBN: 978-1-4577-0545-8**

**Description**

<u>Field of invention</u>

The invention relates to the calculation of the power flow in the distribution grid.

<u>Background of the invention</u>

Power flow calculation is an important part of distribution grid analysis. Based on certain grid prototype and operation conditions, it can confirm the grid's electric status, such as node voltage, branch current and line loss, etc. These results are important for grid planning.

Distribution grid, unlike the transmission grid, has the following features:

- the main structure of distribution grid is radial network rather than meshed one;
- as the ratio of line resistor and reactance (R/X) is relatively big, the convergence of algorithm is the most important in distribution system power flow calculation;
- owing to the integration of distributed generations, the connection of new load types (storage, electric vehicle, etc.), the calculation of power flow becomes more complex in middle voltage (abbreviated MV hereafter) and low voltage (abbreviated LV hereafter) systems.

One of the main algorithms for power flow calculation in distribution grid is backward/forward sweep algorithm. In that kind of algorithm:

- a first step is carried out for a backward calculation. More precisely, a rated voltage is set as reference voltage of all nodes in the grid, and on the basis of load capacity, the rated voltage is calculated from the end point to the root point (departure point of the feeder) gradually. Only relevant line losses and branch currents are calculated, while the node voltage is kept as rated voltage. In the end, the total power at departure node can be obtained; and
- a second step is carried out for the forward calculation: on the basis of the total computed power and initial voltage at root node, voltage drop is calculated gradually along with the feeder in order to finalize the voltage at each node;
- the two steps above being repeated until the deviation of voltage or power between two iterations at each node reaches a tolerance threshold value.

In particular, backward/forward sweep algorithm is applied in the solution of load flow in radially operated distribution networks and can be summarized in the following algorithm:

- In first step, network data including parameters, topology description, voltage magnitude at the source node(s) and loads at nominal voltage are read.
- In second step, it is assumed that a voltage magnitude for each node for the initial load estimation and calculation of loads is dependent on the voltage magnitude.
- In third step, the equivalent for each node is calculated in "upstream (backward)" iteration, from end nodes to source nodes. This is done by summing up all loads of the network fed through the node, including losses.
- In fourth step, starting from the source node(s) and using equation below, the load voltage ($V_r$) is calculated for all loads:

$$V_r^4 + [2(PR + QX) - V_s^2] * V_r^2 + (P^2 + Q^2) * (R^2 + X^2) = 0$$

where $s$ is source side node, $r$ is load side of receiving node, $V_s$ is source side voltage magnitude, $V_r$ is load side voltage magnitude, $P$ is active power, $Q$ is reactive power, $R$ is branch resistance, and $X$ is reactance.

This is the "downstream (forward)" iteration, from source nodes to end nodes.

- In fifth step, the losses are recalculated with the new voltages. If the total losses variation with respect to the previous calculated value is greater than a specified error, third and fourth steps are repeated. Otherwise, all other required results, such as currents, are calculated.

As a result of power flow calculation of main grid, all the values including voltage level and P/Q (active power P divided by reactive power Q, or, in other words, ratio of active power P and reactive power Q) in each MV node can be obtained. Consequently, the above described algorithm can also output other electric parameters such as current, power, etc.

With the use of renewable resources of energy such as photovoltaic panels in households is becoming more and more common, the above described method becomes impractical. The renewable resources, e.g. the photovoltaic panels, represent a new power source. The added power source needs to be dealt with, but the known methods have to re-calculate the power flow with all the components in the network. Usually, there are over 5000 components in the grid. This makes the method rather complicated and requiring sufficiently long computing time and enough computer resources.

Alternative methods are for example loop impedance based algorithm, Newton algorithm, or improved fast decoupled algorithm. A basic overview of these methods is given below.

The loop impedance-based algorithm expresses the load at each node by constant impedance, and assumes that there's a loop from the root node to each load node. Based on Kirchhoff Law, the loop current is taken as variable, and the following set of equations can be obtained:

$$
\begin{cases}
\dot{V}_1 = \dot{Z}_{1,1}\dot{I}_1 + \dot{Z}_{1,2}\dot{I}_2 + \cdots + \dot{Z}_{1,m}\dot{I}_m \\
\quad\quad\quad \vdots \\
\dot{V}_n = \dot{Z}_{n,1}\dot{I}_1 + \dot{Z}_{n,2}\dot{I}_2 + \cdots + \dot{Z}_{n,m}\dot{I}_m
\end{cases}
$$

where $\dot{V}$ is the voltage in the node, $\dot{Z}$ is the impedance of the branch, and $\dot{I}$ is the current in the branch. The dot above the respective quantity denotes the fact that the quantity is complex.

These equations are solved in order to obtain the loop current, which is also the load current at each load node. Then the voltage drop of each branch can be calculated and the voltage and power at each node can be obtained. The above calculation is iterated until the calculated node power is close to the given threshold value.

Newton Algorithm expresses the power flow equation as Taylor Series and neglects the 2nd and higher-order items, and then gets the correction equation. The correction equation is expressed as:

$$
\begin{bmatrix} \Delta P \\ \Delta Q \end{bmatrix} = - \begin{bmatrix} \dfrac{\partial \Delta P}{\partial \theta} & \dfrac{\partial \Delta P}{\partial V} \\ \dfrac{\partial \Delta Q}{\partial \theta} & \dfrac{\partial \Delta Q}{\partial V} \end{bmatrix} \begin{bmatrix} \Delta \theta \\ \Delta V \end{bmatrix}
$$

Improved fast decoupled algorithm is an improvement of Newton Algorithm, developed in order to reduce the memory space and increase calculation speed. Based on the features of high voltage power system that (a) active power P is mainly decided by power angle and (b) reactive power Q is mainly decided by voltage, the correction equation is refined as:

$$
\begin{cases}
\Delta P / U = B' \Delta \theta \\
\Delta Q / U = B'' \Delta U
\end{cases}
$$

where $B'$ is node susceptance matrix and $B''$ is the imaginary part of node susceptance matrix.

These methods, i.e. loop impedance based algorithm, Newton algorithm, or improved fast decoupled algorithm, are not suitable alternatives to the backward/forward algorithm for the following reasons:

- Loop impedance-based algorithm relies on the iterative calculation of node voltage, and, during each iteration, the method of superposition is applied. This method is suitable for weak looped grid, but it cannot deal with the grid with photovoltaic (abbreviated PV hereafter) node.
- Newton algorithm is very sensitive to the initial value. As the voltage at end node in distribution grid is normally low, this method's convergence is bad in the application of distribution grid.
- Improved fast decoupled algorithm is the improvement of Newton algorithm, but it's also sensitive to the ratio of R/X (ratio between line resistor and reactance).When it's applied in distribution grid, either the time of a single iteration is too long, or convergence cannot be reached.

Relevant prior-art is described in MEIJUN LIN ET AL: "Power Prediction Model of Grid-Connected Photovoltaic and Power Flow Analysis",POWER AND ENERGY ENGINEERING CONFERENCE (APPEEC), 2012 ASIA-PACIFIC, IEEE, 27 March 2012 (2012-03-27), pages 1-4, XP032239708,DOI: 10.1109/ APPEEC.2012.6307195ISBN: 978-1-4577-0545-8 and in US 2013/204556 A1.

Therefore, a new alternative method of power flow calculation is needed. The present invention aims to provide such alternative method and thus improve the above described situation. In particular, the present invention aims at providing a method which would require less time and/or computer resources but which would be precise enough.

Summary of the invention

To that end, the invention provides a method for calculation of power flow in the distribution grid, comprising the steps of:

- dividing the distribution grid into two parts, middle voltage grid and one or more low voltage grids;
- pre-processing all low voltage grids in order to estimate a total equivalent power;
- performing a backward/forward type sweep algorithm upon the middle voltage grid only;
- after middle voltage power flow computation, refining all low voltage grid parameters based on middle voltage grid parameter obtained in the previous step, said parameter being one of voltage, current, power, and impedance.

In the embodiments of the invention, one or more of the following steps/features may be used:

* the estimation of the total equivalent power during pre-processing the low voltage grid stakes into account all loads, all sources of energy, such as photovoltaic panels, and line losses for each low voltage feeder;
* the method comprises the following steps:

- for each low voltage sub-grid, make up tree-type form of its structure
- for middle voltage part of the grid, make up tree-type form of its structure
- for each source of energy, calculate the reactive power Q based on active power P, current I, and initial voltage U
- sum up loads, sources of energy, and line loss
- calculate node voltage and branch current by backward/forward sweep
- calculate node voltage, branch current and reactive power Q of energy sources;

* the step of summing up loads, sources of energy, and line loss comprises the following sub-steps:

- sum the loads at node n up to the node n+1, until arriving the root node at the secondary side of the distribution transformer,
- transfer the load at distribution transformer's secondary side to its primary side.

* the step of calculation node voltage and branch current by backward/forward sweep comprises the following sub-steps:

- in the backward sweep, the line current is modified,
- in forward sweep, node voltage is modified,

wherein after each backward/forward sweep step, a convergence condition is checked;
* checking the convergence condition comprises the following sub-steps:

- calculate a correction of each node voltage as

$$\Delta U_k(i) = \left| \dot{U}_k(i) - \dot{U}_k(i-1) \right|,$$

- find a maximum value of the corrections,
- in deciding whether the convergence condition is reached, decide whether the following condition is fulfilled for

$\varepsilon$ being pre-set threshold number:

$$\max(\Delta U_k(i)) < \varepsilon.$$

* the step of calculation of node voltage, branch current and reactive power Q of energy sources comprises the following sub-steps:

a) refine branch current and node voltage from root-point to each end point based on middle voltage grid end-point voltage and ratio of active power P and reactive power Q, P/Q, estimated during summing up loads, sources of energy, and line loss,
b) refine reactive power Q of source of energy based on end-point voltage calculated in step a).

* at least one of the following steps:

- for each low voltage sub-grid, make up tree-type form of its structure
- for middle voltage part of the grid, make up tree-type form of its structure

comprises the following sub-steps:

- search the end nodes as first-layer nodes,
- search the father node of the end nodes as second-layer nodes,
- search the father node of the second-layer nodes as third-layer nodes
- repeat the previous step until all of the father nodes of certain layer is the root node,
- delete the repeated node which has been covered in the former searches.

The above defined method enables the calculation of the power flow in the grid even when the photovoltaic panels (or other renewable sources) are present. It simplifies the calculation, thus limiting the time and resource demands of the calculation. In particular, as per the validation, the iteration number of the proposed method is smaller than that of conventional backward/forward sweep algorithm, which also means the method according to the invention completes the calculations faster than the conventional backward/forward sweep algorithm. The proposed method is stable and convergent.

Additionally, the databases of the MV grid and the LV grid are normally separated. Therefore, it is not easy to complete the power flow calculation in an integrated process. The present method avoids this problem.

Further to the above described method, the present invention aims also at a device for calculating a power flow in a distribution grid, wherein said device comprises at least:

- an input interface so as to receive an input information comprising distribution grid information,
- a processing unit so as to:

* divide the distribution grid into two parts, middle voltage grid and one or more low voltage grids
* pre-process all low voltage grids in order to estimate a total equivalent power;
* perform a backward/forward type sweep algorithm upon the middle voltage grid only;

- and, after middle voltage power flow computation, refine all low voltage grid parameters based on middle voltage grid parameter obtained in the previous step, said parameter being one of voltage, current, power, and impedance,
- an output interface, to deliver said refined low voltage grid parameters. Further to the above described method and device, the present invention provides a computer program comprising instructions which, when the program is executed by a computer, cause the computer to carry out the method according to the invention.

Brief description of the drawings

The present invention is illustrated by way of example, and not by way of limitation, in the figures of the accompanying drawings, in which like reference numerals refer to similar elements and in which:

- Figure 1 shows schematically the distribution grid, with one low voltage (LV) grid and plurality of photovoltaic panels (PVs);

- Figure 2 shows a general flowchart corresponding to a possible general algorithm of a computer program according to an embodiment of the invention;

- Figure 3a is a flow chart showing steps of a method according to an embodiment of the invention;

- Figure 3b is a flow chart showing sub-steps of step S1

- Figure 3c is a flow chart showing sub-steps of step S2

- Figure 3d is a flow chart showing sub-steps of step S4

- Figure 3e is a flow chart showing sub-steps of step S5

- Figure 3f is a flow chart showing sub-steps of step S5-3

- Figure 3g is a flow chart showing sub-steps of step S6

- Figure 4 shows a distribution transformer with configuration D/yn11,

- Figure 5 shows an example of the middle voltage (MV) part of the distribution grid, configured as ungrounded three-phase three-line system,

- Figure 6 shows a device for performing the method shown on figure 2 and figures 3a to 3g.

Detailed description

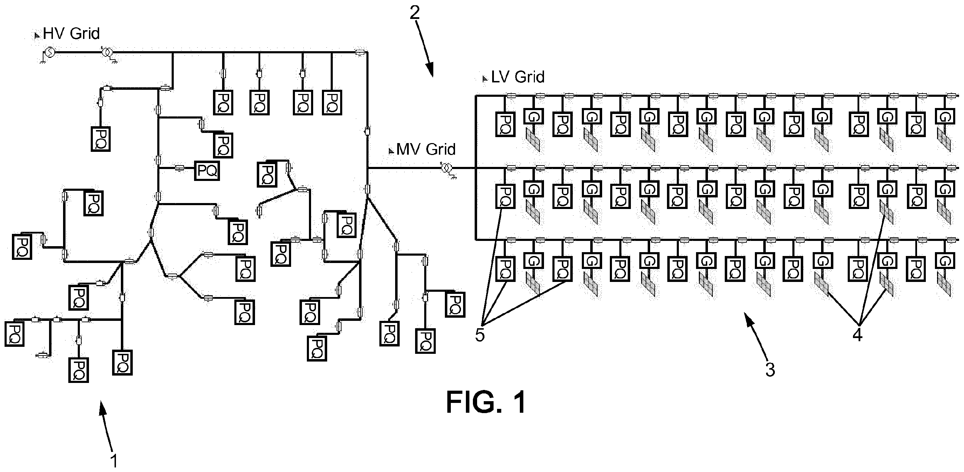

Figure 1 shows an example of a distribution grid. The grid comprises a HV (high voltage) grid 1, a MV (middle voltage) grid 2 and a LV (low voltage) grid 3. The MV grid 2 interconnects the HV grid 1 and the LV grid 3. The LV grid represents for example homes, i.e. the end customer of the distribution. The LV grid is further divided into plurality of energy-consuming entities or loads 5 (typically, homes with various appliances; storages, electric vehicles, etc. may also be included in the loads) and energy-producing entities 4 (for example photovoltaic panels or other energy sources).In order to simplify the following description, the (renewable) sources of energy are described as photovoltaic panels. However, it should be understood that whenever a photovoltaic panel or PV is referred to, it can be replaced by other sources (such as solar thermal power plant, wind or water power plants, or the like).

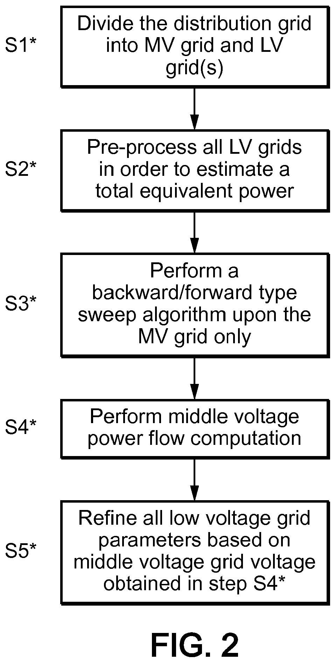

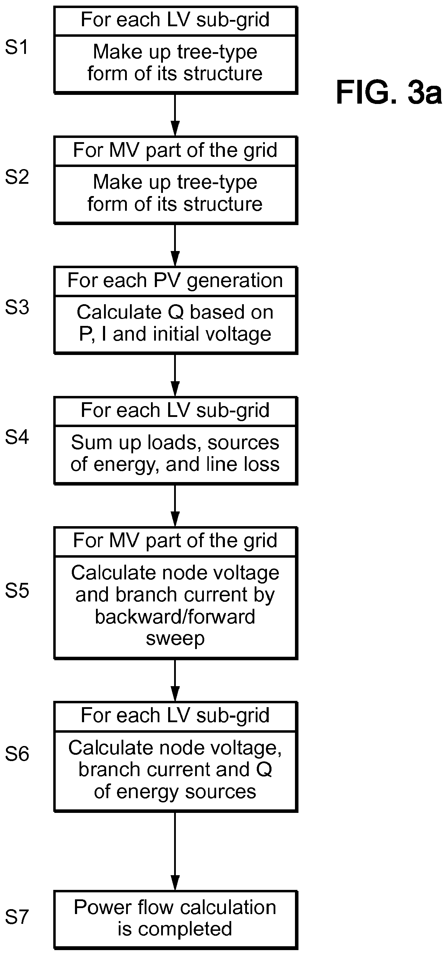

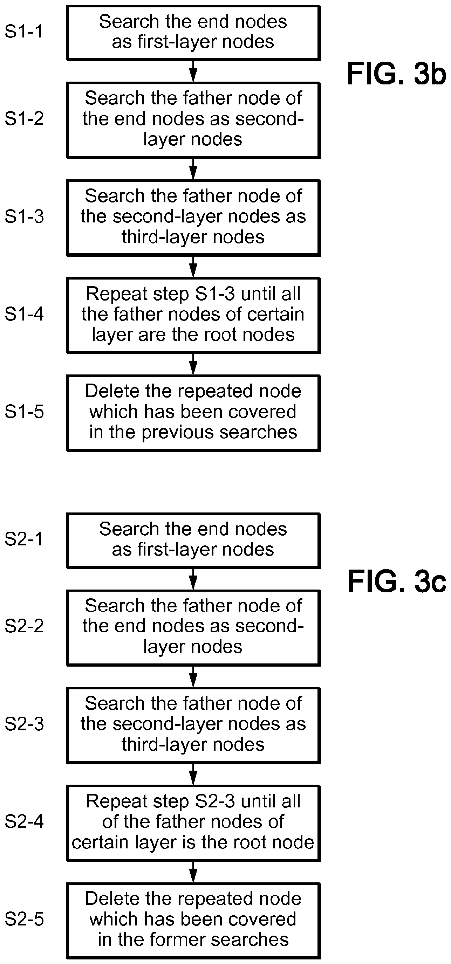

The overview of the example method for calculation of power flow in the distribution grid according to an embodiment of the invention is shown in figure 2. An overview of a more specific example is shown in figure 3a; more specific example of all the method steps is shown in figures 3b to 3g. In the example given in the figures and described below, the main quantity calculated is voltage. It should be understood that the method does not necessarily have to output voltage, but can output all electric parameters such as current, power, etc.

Figure 2 shows an overview of the method in an example of embodiment, the method comprising the following steps:

S1*: Divide the distribution grid into MV grid and LV grid(s).
S2*: Pre-process all LV grids in order to estimate a total equivalent power.
S3*: Perform a backward/forward type sweep algorithm upon the MV grid only.
S4*: Perform middle voltage power flow computation.
S5*: Refine all low voltage grid parameters based on middle voltage grid voltage obtained in step S4*.

Figure 3a gives a more detailed overview of the example method. In step S1, for each LV sub-grid, the nodes are searched and the relationship to get tree-type structure is built. In a corresponding algorithm, data formats may be defined as below:

- node construct: {node number, P, Q};
- branch construct: {node number of the start point, node number of the end point, R, X},

where P is the respective active power, Q is the respective reactive power, R is the respective line resistor and X is the respective reactance.

According to the start point and end point of a branch, the nodes with which a node is connected can be solidified, and the tree-type form of the structure of the LV sub-grid can be achieved. A breadth-first search algorithm based on multiple in-layer traversals is preferably adopted, the algorithm performing the following sub-steps (see in particular figure 3b):

S1-1: Search the end nodes as first-layer nodes;
S1-2: Search the father node of the end nodes as second-layer nodes;
S1-3: Search the father node of the second-layer nodes as third-layer nodes, etc.
S1-4: Repeat step S1-3 until all the father nodes of certain layer are the root nodes;
S1-5: Delete the repeated node which has been covered in the previous searches.

In step S2, for the MV part of the distribution grid, the nodes are searched and the relationship is built to get tree-type form of its structure. The data formats may be defined as below:

- node construct: {node number, P, Q};
- branch construct: {node number of the start point, node number of the end point, R, X},

where P is the respective active power, Q is the respective reactive power, R is the respective line resistor and X is the respective reactance.

According to the start point and end point of a branch, the nodes with which a node is connected can be solidified, and the tree-type form of structure of the MV part of the distribution grid can be achieved. A breadth-first search algorithm based on multiple in-layer traversals is preferably adopted, the algorithm performing the following sub-steps (see figure 3c):

S2-1: Search the end nodes as first-layer nodes;
S2-2: Search the father node of the end nodes as second-layer nodes;
S2-3: Search the father node of the second-layer nodes as third-layer nodes, etc.
S2-4: Repeat step S2-3 until all of the father nodes of certain layer is the root node;
S2-5: Delete the repeated node which has been covered in the former searches.

Usually, each PV generation is integrated to the grid by current-controlled inverter. In step S3, the current-controlled inverter can be modelled as PI node which has constant active power P and current I. The reactive power Q of the PV generation can then be calculated from active power P, current I, and voltage V. As the actual voltage V of the PV generation is unknown before the power flow calculation, it's replaced by initial voltage, for example the rated voltage U:

$$Q = \sqrt{I^2 \times U^2 - P^2}$$

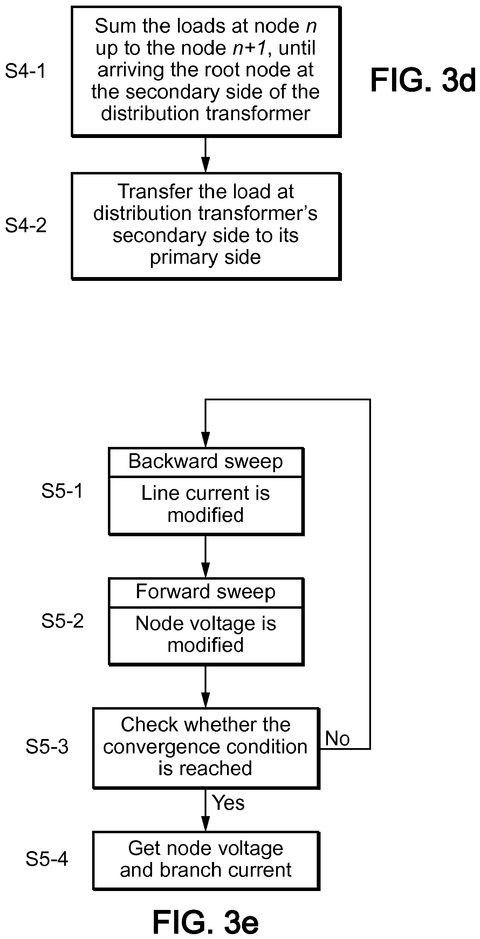

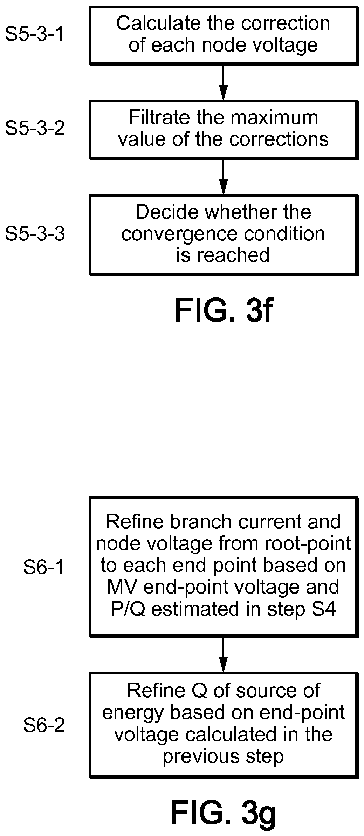

In step S4, to simplify the power flow calculation, a rough summary of the loads, PVs and line losses is made before starting power flow calculation. In other words, all loads and PVs are summed up from the terminal nodes to the distribution transformer whose coil connection is normally configured as D/yn11, shown on figure 3. To perform the above described summing up, the following steps may be carried out (see figure 3d):
Step S4-1: Sum the loads at node *n* up to the node *n+1*, until arriving to the root node at the secondary side of the distribution transformer. The algorithm for each step is described as below:

$$\dot{S}_{sum,n+1} = \dot{S}_n + \dot{S}_{sum,n} + \dot{S}_{line\_loss,n,n+1} \text{ ,}$$

where $\dot{S}$ is complex power.
As the current from node *n* to node *n+1* is unknown before the calculation of power flow, an estimation of the value of $\dot{S}_{line\_loss,n,n+1}$ is to be made as follows:

$$\dot{S}_{line\_n\_n+1,SC} = \frac{\dot{U}_0^2}{\dot{Z}_{line\_n\_n+1}}$$

$$\dot{S}_{line\_loss,n,n+1} = \dot{k}_{line\_n\_n+1} \times \dot{S}_{sum,n}$$

$$\dot{k}_{line\_n\_n+1} = \frac{\dot{S}_{sum,n}}{\dot{S}_{line\_n\_n+1,SC} - \dot{S}_{sum,n}}$$

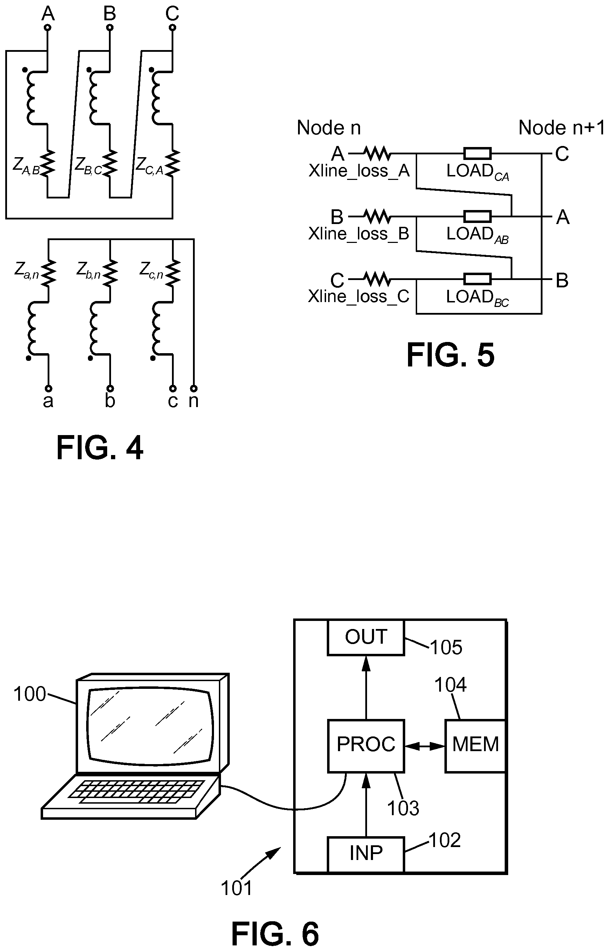

where $\dot{Z}$ is the impedance between node_n and node_n+1 and $\dot{k}$ is a coefficient to estimate the loss in the line. Step S4-2: Transfer the load at distribution transformer's secondary side to its primary side. A distribution transformer with configuration of D/yn11 is shown in figure 4. For an ideal transformer:

$$\dot{S}_{AB} = \dot{S}_{an}$$

$$\dot{S}_{BC} = \dot{S}_{bn}$$

$$\dot{S}_{CA} = \dot{S}_{cn} .$$

In practice, the loss of the transformer should be considered, so

$$\dot{S}_{AB} = \dot{S}_{an} + \dot{S}_{transformer\_loss,AB}$$

$$\dot{S}_{BC} = \dot{S}_{bn} + \dot{S}_{transformer\_loss,BC}$$

$$\dot{S}_{CA} = \dot{S}_{cn} + \dot{S}_{transformer\_loss,CA} .$$

For each phase seen from primary side,

$$\dot{Z}_{tranfromer\_loss} = \dot{Z}_{primary} + n^2 \times \dot{Z}_{secondary}$$

and:

$$\dot{S}_{tranformer,SC} = \frac{\dot{U}_0^2}{\dot{Z}_{transformer\_loss}}$$

$$\dot{S}_{tranformer\_loss} = \dot{k}_{transformer} \times \dot{S}_{xn}$$

$$\dot{k}_{transformer} = \frac{\dot{S}_{xn}}{\dot{S}_{transformer\_loss} - \dot{S}_{xn}}$$

In step S5, the power flow of the MV part of the distribution grid is calculated by backward/forward sweep.

For the MV part of the distribution grid, it's normally configured as ungrounded three-phase three-line system as shown in figure5.

The relationship between voltage values and current values are expressed as below:

$$\begin{bmatrix} \dot{I}_{n+1,A} \\ \dot{I}_{n+1,B} \\ \dot{I}_{n+1,C} \end{bmatrix} = \begin{bmatrix} \dot{I}_{n+1,AB} - \dot{I}_{n+1,CA} \\ \dot{I}_{n+1,BC} - \dot{I}_{n+1,AB} \\ \dot{I}_{n+1,CA} - \dot{I}_{n+1,BC} \end{bmatrix} + \begin{bmatrix} \dot{I}_{n,A} \\ \dot{I}_{n,B} \\ \dot{I}_{n,C} \end{bmatrix}$$

$$\begin{bmatrix} \dot{V}_{drop,n+1,A} \\ \dot{V}_{drop,n+1,B} \\ \dot{V}_{drop,n+1,C} \end{bmatrix} = \begin{bmatrix} \dot{Z}_{n,n+1,A} & 0 & 0 \\ 0 & \dot{Z}_{n,n+1,B} & 0 \\ 0 & 0 & \dot{Z}_{n,n+1,C} \end{bmatrix} \begin{bmatrix} \dot{I}_{n,A} \\ \dot{I}_{n,B} \\ \dot{I}_{n,C} \end{bmatrix}$$

$$\begin{bmatrix} \dot{V}_{n+1,AB} \\ \dot{V}_{n+1,BC} \\ \dot{V}_{n+1,CA} \end{bmatrix} = \begin{bmatrix} \dot{V}_{n,AB} \\ \dot{V}_{n,BC} \\ \dot{V}_{n,CA} \end{bmatrix} + \begin{bmatrix} \dot{V}_{drop,n+1,A} - \dot{V}_{drop,n+1,B} \\ \dot{V}_{drop,n+1,B} - \dot{V}_{drop,n+1,C} \\ \dot{V}_{drop,n+1,C} - \dot{V}_{drop,n+1,A} \end{bmatrix}$$

Step S5-1: backward sweep from the first level to the root node to get line current with an initial voltage.

For the first level:

$$\dot{I} = \frac{\dot{S}}{\dot{U}_{ini}} = \frac{P}{U_{ini}} - i \times \frac{Q}{U_{ini}}$$

For the other (i.e. second, third etc.) levels:

$$\dot{I}_k = \frac{\dot{S}_k}{\dot{U}_{ini}} + \sum \dot{I}_{k-1}$$

Step S5-2: forward sweep from the root node to the first level to get node voltage with the voltage at root node.

$$\dot{U}_n = \dot{U}_{n+1} - \dot{I}_{n,n+1} \dot{Z}_{n,n+1}$$

Step S5-3 preferably comprises the following sub-steps (see figure 3f):

Step S5-3-1. Calculate the correction of each node voltage

$$\Delta U_k(i) = \left| \dot{U}_k(i) - \dot{U}_k(i-1) \right|$$

Step S5-3-2. Find the maximum value of the corrections;
Step S5-3-3. Decide whether the convergence condition is reached, i.e. whether the following condition is fulfilled ($\varepsilon$ is pre-set threshold number):

$$\max(\Delta U_k(i)) < \varepsilon$$

In step S6, for each LV sub-grid, the branch current and the node voltage from distribution transformer to end-point loads and PVs is refined. Preferably, the following sub-steps are performed to carry out step S6.

Step S6-1: At the node of distribution transformer,

$$\dot{I} = \frac{\dot{S}_{estimated}}{\dot{U}_{calculated}}$$

where $\dot{S}_{estimated}$ is the active power P and reactive power Q estimated in step S4, and $\dot{U}_{calculated}$ is the voltage calculated by backward/forward sweep in step S5.

For the node voltage at next level, the following equation applies:

$$\dot{U}_n = \dot{U}_{n+1} + \dot{Z}_{n,n+1}\dot{I}$$

For the node that has several branches, the following equation applies

$$\dot{I}_{k,n} = \frac{\dot{S}_k}{\sum \dot{S}} \dot{I}_{n+1}$$

Step S6-2: According to the voltage at end-point nodes, the reactive power Q generated by PVs is refined as

$$Q = \sqrt{I^2 \times U^2 - P^2}$$ .

It should be understood that the above described method is provided as an example. In order to simplify the description, the main quantity calculated in the example is voltage. It should be understood that as the result of power flow calculation of HV grid, all the values including voltage level and P/Q (i.e. the ratio of active power P and reactive power Q) in each MV node can be obtained; the method does not necessarily have to output voltage, but can output all electric parameters such as current, power, etc.

The above described method can easily be implemented by a computer; corresponding device is schematically shown on figure 6 and described here below.

In particular, the computer 100 comprises:

- an input interface 102, which receives the input information (i.e. the information about the HV, MV and LV grids, the overall structure of the grid, initial voltage U),
- a processing unit 103 (a processor, or an FPGA, or a DSP, etc.),
- a memory unit 104, which stores a) the initial values and intermediate results of the respective method steps and b) the instructions for the processing unit 103 in form of a computer program, and
- an output interface 105, which outputs the computed values of voltage (or other parameters).

The computed values of voltage (or other parameters) which are output by the output interface 105 may then be used for obtaining the load flow. These values are important for power grid planning and/or power grid management. With the increasing use of sources of energy such as photovoltaic panels being possibly exploited by individual users, the power grid planning and management get more complicated. However, with the new energy sources and new load types, it is important to efficiently and flexibly get adapted to the power flow in the network. This may in turn help preventing from distribution problems, which may ultimately result in a blackout.

The memory unit 104 may be divided into a working memory, which stores the initial values, intermediate results and/or the output values, and a memory such as a non-transitory computer storage medium for storing the instructions for the processing unit 103 in form of a computer program. As mentioned above, the data formats in steps S1 and S2 may be as follows:

- node construct: {node number, P, Q};
- branch construct: {node number of the start point, node number of the end point, R, X},
  where P is the respective active power, Q is the respective reactive power, R is the respective line resistor and X is the respective reactance.

The processing unit 103 is configured to execute the instructions for the processing unit 103 in form of a computer program, stored in the memory 104. The main algorithm of such a computer program can correspond as for example to the method steps described above with reference to figures 2 to 5. Based on the input information and the instructions of the computer program, the processing unit 103 performs the respective method steps S1 * to S5* or S1 to S7 (including possibly some or all the sets of sub-steps S1-1 to S1-5, S2-1 to S2-5, S4-1 to S4-2, S5-1 to S5-4, S5-3-1 to S5-3-3, and/or S6-1 to S6-2), respectively. The processing unit 103 outputs, through the output interface 105, the computed values of voltage (or other parameters).

Of course, the present invention is not limited to the description provided above as an example of embodiment; it encompasses possible variants. Typically, it has been disclosed above a method based on voltage to provide refined low voltage grid parameters. However, the invention may use alternatively parameters such as current, power, or impedance to that end.

**Claims**

1. A method for calculation of power flow in a distribution grid, comprising the steps of:

   - dividing the distribution grid into two parts, middle voltage grid and one or more low voltage grids;
   - pre-processing all low voltage grids in order to estimate a total equivalent power;
   - performing a backward/forward type sweep algorithm upon the middle voltage grid only;
   - after middle voltage power flow computation, refining all low voltage grid parameters based on middle voltage grid parameter obtained in the previous step, said parameter being one of voltage, current, power, and impedance.

2. Method according to claim 1, wherein the estimation of the total equivalent power during pre-processing the low voltage grid stakes into account:

   - all loads,
   - all sources of energy, such as photovoltaic panels,
   - line losses for each low voltage feeder.

3. Method according to any one of the previous claims, wherein the method comprises the following steps:

   - for each low voltage sub-grid, make up tree-type form of its structure
   - for middle voltage part of the grid, make up tree-type form of its structure
   - for each source of energy, calculate the reactive power Q based on active power P, current I, and initial voltage U
   - sum up loads, sources of energy, and line loss
   - calculate node voltage and branch current by backward/forward sweep
   - calculate node voltage, branch current and reactive power Q of energy sources.

4. Method according to claim 3, wherein the step of summing up loads, sources of energy, and line loss comprises the following sub-steps:

   - sum the loads at node n up to the node n+1, until arriving the root node at the secondary side of the distribution transformer,
   - transfer the load at distribution transformer's secondary side to its primary side.

5. Method according to claim 4, wherein the step of calculation node voltage and branch current by backward/forward sweep comprises the following sub-steps:

   - in the backward sweep, the line current is modified,
   - in forward sweep, node voltage is modified,

   and wherein after each backward/forward sweep step, a convergence condition is checked.

6. Method according to any one of claims 4 or 5, wherein checking the convergence condition comprises the following sub-steps:

   - calculate a correction of each node voltage as

$$\Delta U_k(i) = \left| \dot{U}_k(i) - \dot{U}_k(i-1) \right|,$$

- find a maximum value of the corrections,
- in deciding whether the convergence condition is reached, decide whether the following condition is fulfilled for $\varepsilon$ being pre-set threshold number:

$$\max(\Delta U_k(i)) < \varepsilon.$$

7. Method according to any one of claims 4 to 6, wherein the step of calculation of node voltage, branch current and reactive power Q of energy sources comprises the following sub-steps:

a) refine branch current and node voltage from root-point to each end point based on middle voltage grid end-point voltage and ratio of active power P and reactive power Q, P/Q, estimated during summing up loads, sources of energy, and line loss,
b) refine reactive power Q of source of energy based on end-point voltage calculated in step a).

8. Method according to any one of claims 4 to7, wherein at least one of the following steps:

- for each low voltage sub-grid, make up tree-type form of its structure
- for middle voltage part of the grid, make up tree-type form of its structure

comprises the following sub-steps:

- search the end nodes as first-layer nodes,
- search the father node of the end nodes as second-layer nodes,
- search the father node of the second-layer nodes as third-layer nodes
- repeat the previous step until all of the father nodes of certain layer is the root node,
- delete the repeated node which has been covered in the former searches.

9. A device for calculating a power flow in a distribution grid, wherein said device comprises at least:

- an input interface (102) so as to receive an input information comprising distribution grid information,
- a processing unit (103) so as to:

* divide the distribution grid into two parts, middle voltage grid and one or more low voltage grids
* pre-process all low voltage grids in order to estimate a total equivalent power;
* perform a backward/forward type sweep algorithm upon the middle voltage grid only;

- and, after middle voltage power flow computation, refine all low voltage grid parameters based on said middle voltage grid parameter, said parameter being one of voltage, current, power, and impedance,

- an output interface (105), to deliver said refined low voltage grid parameters.

10. Computer program comprising instructions which, when the program is executed by a computer, cause the computer to carry out the method according to any one of claims 1 to 8.

**Patentansprüche**

1. Verfahren zum Berechnen eines Leistungsflusses in einem Verteilungsnetz, umfassend die folgenden Schritte:

- Teilen des Verteilungsnetzes in zwei Teile, ein Mittelspannungsnetz und ein oder mehrere Niederspannungsnetze;
- Vorverarbeiten aller Niederspannungsnetze, um eine Gesamtäquivalentleistung zu schätzen;

- Durchführen eines Sweep-Algorithmus vom Rückwärts-/Vorwärtstyp nur an dem Mittelspannungsnetz;
- nach einer Mittelspannungsleistungsflussberechnung, Filtern aller Niederspannungsnetzparameter basierend auf einem in dem vorhergehenden Schritt erhaltenen Mittelspannungsnetzparameter, wobei der Parameter eines aus einer Spannung, einem Strom, einer Leistung und einer Impedanz ist.

2. Verfahren nach Anspruch 1, wobei das Schätzen der Gesamtäquivalentleistung während des Vorverarbeitens der Niederspannungsnetze berücksichtigt:

- alle Lasten,
- alle Energiequellen, wie etwa Photovoltaikpaneele,
- alle Leitungsverluste für jeden Niederspannungseinspeiser.

3. Verfahren nach einem der vorhergehenden Ansprüche, wobei das Verfahren die folgenden Schritte umfasst:

- für jedes Niederspannungsteilnetz, Bilden einer Baumtypform seiner Struktur,
- für einen Mittelspannungsteil des Netzes, Bilden einer Baumtypform seiner Struktur,
- für jede Energiequelle, Berechnen der Blindleistung Q basierend auf Wirkleistung P, Strom I und Anfangsspannung U,
- Summieren von Lasten, Energiequellen und einem Leitungsverlust,
- Berechnen einer Knotenspannung und eines Teilstroms durch einen Rückwärts-/Vorwärts-Sweep,
- Berechnen einer Knotenspannung, eines Teilstroms und einer Blindleistung Q von Energiequellen.

4. Verfahren nach Anspruch 3, wobei der Schritt des Summierens von Lasten, Energiequellen und einem Leitungsverlust die folgenden Unterschritte umfasst:

- Summieren der Lasten an dem Knoten n zu dem Knoten n+1, bis der Wurzelknoten an der sekundären Seite des Verteilungstransformators erreicht wird,
- Übertragen der Last an der sekundären Seite des Verteilungstransformators zu seiner primären Seite.

5. Verfahren nach Anspruch 4, wobei der Schritt des Berechnens einer Knotenspannung und eines Teilstroms durch einen Rückwärts-/Vorwärts-Sweep die folgenden Unterschritte umfasst:

- in dem Rückwärts-Sweep wird der Leitungsstrom geändert,
- in dem Vorwärts-Sweep wird die Knotenspannung geändert,
und wobei nach jedem Rückwärts-/Vorwärts-Sweep-Schritt eine Konvergenzbedingung geprüft wird.

6. Verfahren nach einem der Ansprüche 4 oder 5, wobei das Prüfen der Konvergenzbedingung die folgenden Unterschritte umfasst:

- Berechnen einer Korrektur jeder Knotenspannung als

$$\Delta U_k(i) = \left|\dot{U}_k(i) - \dot{U}_k(i-1)\right|,$$

- Finden eines Maximalwerts der Korrekturen,
- bei einem Entscheiden, ob die Konvergenzbedingung erreicht ist, Entscheiden, ob die folgende Bedingung für $\varepsilon$ als eine voreingestellte Schwellenzahl erfüllt ist:

$$\max\left(\Delta U_k(i)\right) < \varepsilon.$$

7. Verfahren nach einem der Ansprüche 4 bis 6, wobei der Schritt des Berechnens einer Knotenspannung, eines Teilstroms und einer Blindleistung Q von Energiequellen die folgenden Unterschritte umfasst:

a) Filtern eines Teilstroms und einer Knotenspannung von einem Wurzelpunkt zu jedem Endpunkt basierend auf einer Mittelspannungsnetz-Endpunktspannung und einem Verhältnis von Wirkleistung P und Blindleistung Q, P/Q, welches während dem Summieren von Lasten, Energiequellen und einem Leitungsverlust geschätzt wird,

b) Filtern einer Blindleistung Q von Energiequellen basierend auf einer in Schritt a) berechneten Endpunktspannung.

8. Verfahren nach einem der Ansprüche 4 bis 7, wobei wenigstens einer der folgenden Schritte:

- für jedes Niederspannungsteilnetz, Bilden einer Baumtypform seiner Struktur,
- für einen Mittelspannungsteil des Netzes, Bilden einer Baumtypform seiner Struktur,

die folgenden Unterschritte umfasst:

- Suchen der Endknoten als Erstschichtknoten,
- Suchen des Vaterknotens der Endknoten als Zweitschichtknoten,
- Suchen des Vaterknotens der Zweitschichtknoten als Drittschichtknoten,
- Wiederholen des vorhergehenden Schritts, bis jeder der Vaterknoten einer bestimmten Schicht der Wurzelknoten ist,
- Löschen des wiederholten Knotens, welcher in den früheren Suchen abgedeckt worden ist.

9. Vorrichtung zum Berechnen eines Leistungsflusses in einem Verteilungsnetz, wobei die Vorrichtung wenigstens umfasst:

- eine Eingangsschnittstelle (102) zum Empfangen einer Eingangsinformation, welche eine Verteilungsnetzinformation umfasst,
- eine Verarbeitungseinheit (103) zum:

   • Teilen des Verteilungsnetzes in zwei Teile, ein Mittelspannungsnetz und ein oder mehrere Niederspannungsnetze;
   • Vorverarbeiten aller Niederspannungsnetze, um eine Gesamtäquivalentleistung zu schätzen;
   • Durchführen eines Sweep-Algorithmus vom Rückwärts-A/orwärtstyp nur an dem Mittelspannungsnetz;
   • und, nach einer Mittelspannungsleistungsflussberechnung, Filtern aller Niederspannungsnetzparameter basierend auf einem Mittelspannungsnetzparameter, wobei der Parameter eines aus einer Spannung, einem Strom, einer Leistung und einer Impedanz ist,

- eine Ausgangsschnittstelle (105) zum Liefern der gefilterten Niederspannungsnetzparameter.

10. Computerprogramm, umfassend Anweisungen, welche, wenn das Programm durch einen Computer ausgeführt wird, den Computer veranlassen, das Verfahren nach einem der Ansprüche 1 bis 8 durchzuführen.

**Revendications**

1. Procédé de calcul de transit de puissance dans un réseau de distribution, comprenant les étapes consistant à :

- diviser le réseau de distribution en deux parties, un réseau de moyenne tension et un ou plusieurs réseaux de basse tension ;
- prétraiter tous les réseaux de basse tension afin d'estimer une puissance totale équivalente ;
- réaliser un algorithme de balayage de type vers l'arrière/vers l'avant sur le réseau de moyenne tension uniquement ;
- après le calcul de transit de puissance moyenne tension, affiner tous les paramètres de réseaux de basse tension sur la base du paramètre de réseau de moyenne tension obtenu à l'étape précédente, ledit paramètre étant un parmi la tension, le courant, la puissance et l'impédance.

2. Procédé selon la revendication 1, dans lequel l'estimation de la puissance équivalente totale lors du prétraitement des réseaux de basse tension prend en compte :

- toutes les charges,
- toutes les sources d'énergie, telles que les panneaux photovoltaïques,
- les pertes en ligne pour chaque artère de basse tension.

**3.** Procédé selon l'une quelconque des revendications précédentes, dans lequel le procédé comprend les étapes suivantes :

- pour chaque sous-réseau de basse tension, constituer une forme arborescente de sa structure,
- pour la partie moyenne tension du réseau, constituer une forme arborescente de sa structure,
- pour chaque source d'énergie, calculer la puissance réactive Q sur la base de la puissance active P, du courant I et de la tension initiale U,
- additionner des charges, des sources d'énergie et une perte en ligne,
- calculer la tension de nœud et le courant de branche par balayage vers l'arrière/vers l'avant,
- calculer la tension de nœud, le courant de branche et la puissance réactive Q de sources d'énergie.

**4.** Procédé selon la revendication 3, dans lequel l'étape d'addition de charges, de sources d'énergie, et d'une perte en ligne comprend les sous-étapes suivantes :

- additionner les charges au nœud n jusqu'au nœud n + 1, jusqu'à arriver au nœud racine du côté secondaire du transformateur de distribution,
- transférer la charge du côté secondaire du transformateur de distribution à son côté primaire.

**5.** Procédé selon la revendication 4, dans lequel l'étape de calcul de la tension de nœud et du courant de branche par balayage vers l'arrière/vers l'avant comprend les sous-étapes suivantes :

- dans le balayage vers l'arrière, le courant de ligne est modifié,
- dans le balayage vers l'avant, la tension de nœud est modifiée,
et dans lequel après chaque étape de balayage vers l'arrière/vers l'avant, une condition de convergence est vérifiée.

**6.** Procédé selon l'une quelconque des revendications 4 et 5, dans lequel la vérification de la condition de convergence comprend les sous-étapes suivantes :

- calculer une correction de chaque tension de nœud telle que

$$\Delta U_k(i) = \left| \dot{U}_k(i) - \dot{U}_k(i-1) \right|,$$

- trouver une valeur maximale des corrections,
- pour décider si la condition de convergence est atteinte, décider si la condition suivante est remplie pour que $\varepsilon$ soit un nombre seuil prédéfini :

$$\max(\Delta U_k(i)) < \varepsilon.$$

**7.** Procédé selon l'une quelconque des revendications 4 à 6, dans lequel l'étape de calcul de tension de nœud, du courant de branche et de la puissance réactive Q de sources d'énergie comprend les sous-étapes suivantes :

a) affiner le courant de branche et la tension de nœud du point racine à chaque point d'extrémité sur la base de la tension de point d'extrémité de réseau de moyenne tension et du rapport de puissance active P sur la puissance réactive Q, P/Q, estimé lors de l'addition de charges, de sources d'énergie et d'une perte en ligne,
b) affiner la puissance réactive Q de la source d'énergie sur la base de la tension de point d'extrémité calculée à l'étape a).

**8.** Procédé selon l'une quelconque des revendications 4 à 7, dans lequel au moins une parmi les étapes suivantes :

- pour chaque sous-réseau de basse tension, constituer une forme arborescente de sa structure,
- pour la partie moyenne tension du réseau, constituer une forme arborescente de sa structure

comprend les sous-étapes suivantes :

- rechercher les nœuds d'extrémité en tant que nœuds de première couche,
- rechercher le nœud père des nœuds d'extrémité en tant que nœuds de deuxième couche,
- rechercher le nœud père des nœuds de deuxième couche en tant que nœuds de troisième couche,
- répéter l'étape précédente jusqu'à ce que tous les nœuds pères de certaines couches soient le nœud racine,
- supprimer le nœud répété qui a été couvert dans les recherches précédentes.

9. Dispositif de calcul d'un transit de puissance dans un réseau de distribution, dans lequel ledit dispositif comprend au moins :

- une interface d'entrée (102) pour recevoir des informations d'entrée comprenant des informations de réseau de distribution,
- une unité de traitement (103) pour :

* diviser le réseau de distribution en deux parties, un réseau de moyenne tension et un ou plusieurs réseaux de basse tension,
* prétraiter tous les réseaux de basse tension afin d'estimer une puissance totale équivalente ;
* réaliser un algorithme de balayage de type vers l'arrière/vers l'avant sur le réseau de moyenne tension uniquement ;

- et, après le calcul de transit de puissance moyenne tension, affiner tous les paramètres de réseaux de basse tension sur la base dudit paramètre de réseau de moyenne tension, ledit paramètre étant un parmi la tension, le courant, la puissance et l'impédance,
- une interface de sortie (105), pour fournir lesdits paramètres de réseau de basse tension affinés.

10. Programme informatique comprenant des instructions qui, lorsque le programme est exécuté par un ordinateur, amènent l'ordinateur pour mettre en œuvre le procédé selon l'une quelconque des revendications 1 à 8.

FIG. 1

S1* | Divide the distribution grid into MV grid and LV grid(s)

S2* | Pre-process all LV grids in order to estimate a total equivalent power

S3* | Perform a backward/forward type sweep algorithm upon the MV grid only

S4* | Perform middle voltage power flow computation

S5* | Refine all low voltage grid parameters based on middle voltage grid voltage obtained in step S4*

FIG. 2

EP 3 098 924 B1

**FIG. 3a**

| S1 | For each LV sub-grid |
|---|---|
| | Make up tree-type form of its structure |

| S2 | For MV part of the grid |
|---|---|
| | Make up tree-type form of its structure |

| S3 | For each PV generation |
|---|---|
| | Calculate Q based on P, I and initial voltage |

| S4 | For each LV sub-grid |
|---|---|
| | Sum up loads, sources of energy, and line loss |

| S5 | For MV part of the grid |
|---|---|
| | Calculate node voltage and branch current by backward/forward sweep |

| S6 | For each LV sub-grid |
|---|---|
| | Calculate node voltage, branch current and Q of energy sources |

| S7 | Power flow calculation is completed |
|---|---|

**FIG. 3b**

S1-1 — Search the end nodes as first-layer nodes

S1-2 — Search the father node of the end nodes as second-layer nodes

S1-3 — Search the father node of the second-layer nodes as third-layer nodes

S1-4 — Repeat step S1-3 until all the father nodes of certain layer are the root nodes

S1-5 — Delete the repeated node which has been covered in the previous searches

**FIG. 3c**

S2-1 — Search the end nodes as first-layer nodes

S2-2 — Search the father node of the end nodes as second-layer nodes

S2-3 — Search the father node of the second-layer nodes as third-layer nodes

S2-4 — Repeat step S2-3 until all of the father nodes of certain layer is the root node

S2-5 — Delete the repeated node which has been covered in the former searches

| S4-1 | Sum the loads at node *n* up to the node *n+1*, until arriving the root node at the secondary side of the distribution transformer |

**FIG. 3d**

| S4-2 | Transfer the load at distribution transformer's secondary side to its primary side |

| S5-1 | Backward sweep<br>Line current is modified |

| S5-2 | Forward sweep<br>Node voltage is modified |

| S5-3 | Check whether the convergence condition is reached | No |

Yes

| S5-4 | Get node voltage and branch current |

**FIG. 3e**

S5-3-1 | Calculate the correction of each node voltage

S5-3-2 | Filtrate the maximum value of the corrections

S5-3-3 | Decide whether the convergence condition is reached

## FIG. 3f

S6-1 | Refine branch current and node voltage from root-point to each end point based on MV end-point voltage and P/Q estimated in step S4

S6-2 | Refine Q of source of energy based on end-point voltage calculated in the previous step

## FIG. 3g

FIG. 4

FIG. 5

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013204556 A1

**Non-patent literature cited in the description**

- Power Prediction Model of Grid-Connected Photovoltaic and Power Flow Analysis. **MEIJUN LIN et al.** POWER AND ENERGY ENGINEERING CONFERENCE (APPEEC), 2012 ASIA-PACIFIC. IEEE, 27 March 2012, 1-4